# EUROPÄISCHE PATENTSCHRIFT

(11) **EP 2 488 679 B1**
(45) Veröffentlichungstag und Bekanntmachung des Hinweises auf die Patenterteilung: **26.11.2014**
(21) Anmeldenummer: 10763696.1
(22) Anmeldetag: 08.10.2010
(51) Int. Cl.: C23C 16/458, C23C 16/46, C23C 16/48

(54) **CVD-REAKTOR MIT AUF EINEM MEHRERE ZONEN AUFWEISENDEN GASPOLSTER LIEGENDEN SUBSTRATHALTER**
CVD-REACTOR WITH A SUBSTRATE HOLDER HAVING A MULTIPLE ZONE GAS CUSHION
REACTEUR CVD COMPRENANT UN SUPPORT DE SUBSTRAT AYANT PLUSIEURS ZONES À COUSSIN DE GAZ

(30) Priorität: 16.10.2009 DE 102009044276
(43) Veröffentlichungstag der Anmeldung: 22.08.2012
(73) Patentinhaber: Aixtron SE, 52134 Herzogenrath (DE)
(72) Erfinder: RUDA Y WITT, Francisco, 52249 Eschweiler (DE); KÄPPELER, Johannes, 52146 Würselen (DE)
(74) Vertreter: Grundmann, Dirk
(86) Internationale Anmeldenummer: PCT/EP2010/065105
(87) Internationale Veröffentlichungsnummer: WO 2011/045241

(56) Entgegenhaltungen:
- WO-A1-03/008675
- DE-A1-102006 018 514
- DE-A1-102007 026 348
- US-A- 5 177 878
- US-A1- 2008 227 227

## Beschreibung

Die Erfindung betrifft einen CVD-Reaktor mit mindestens einem von einem Substrathalterträger auf einen dynamischen Gaspolster getragenen Substrathalter, der von der Rückseite her mit einer Heizung beheizbar ist.

Die Erfindung betrifft darüber hinaus ein Verfahren zur Temperatursteuerung der Oberflächentemperaturen von auf dynamischen Gaspolstern getragenen und insbesondere drehangetriebenen, von unten beheizten Substrathaltern.

Die DE 10 2006 018 514 A1 beschreibt einen CVD-Reaktor mit einem Reaktorgehäuse, eine in dem Reaktorgehäuse angeordnete Prozesskammer und einen den Boden der Prozesskammer bildenden Substrathalterträger. Dieser besitzt eine Vielzahl von ringförmig um ein Zentrum angeordnete, kreisförmige Lagertaschen, in die Gaszuleitungskanäle münden. In den Taschen liegen kreisscheibenförmige Substrathalterträger ein, die jeweils ein Substrat tragen. Das Substrat wird mit III-V-Halbleiterschichten beschichtet. Die dazu erforderlichen Ausgangsstoffe sind gasförmig und bestehen bspw. aus einer metallorganischen Komponente und einem Hydrid. Die Ausgangsstoffe werden in einem Gasmischsystem mit einem Trägergas gemischt. Die Gasmischung gelangt über getrennte Kanäle in ein Gaseinlassorgan, durch welches die Gase in die Prozesskammer eingeleitet werden. Die Prozesskammer wird von unten beheizt. Dies erfolgt mit einer RF-Heizung oder einer Widerstandsheizung. Über Wärmeleitung wird die Wärme durch den aus Graphit bestehenden Substrathalterträger zu dessen zur Prozesskammer weisenden Oberfläche geleitet. Die zum Substrat transportierte Wärme muss dabei die Barriere eines Spaltes überwinden, der von einem dynamischen Gaslager ausgebildet wird, auf welchem die Substrathalter aufliegen und mittels welchem sie drehangetrieben werden. Die in die Prozesskammer eingeleiteten Gase, bspw. TMGa oder TMIn oder TMAl sowie AsH₃, NH₃ oder PH₃ zerlegen sich pyrolytisch. Die Zerlegungsreaktion findet vorrangig an der heißen Oberfläche des Prozesskammerbodens und auf der Oberfläche des von unten beheizten Substrates statt. Die Wachstumsrate bzw. die Schichtzusammensetzung oder Kristallqualität hängt in hohem Maße von der jeweiligen örtlichen Oberflächentemperatur ab. Um eine möglichst hohe laterale Temperaturhomogenität zu bekommen, wird von der DE 10 2006 018 514 A1 vorgeschlagen, die Spalthöhe zwischen Boden der Lagertasche und Rückseite des Substrathalters verschieden hoch zu gestalten, so dass dadurch der Wärmefluss vom Substrathalterträger zum Substrathalter örtlich verschieden ist. Durch eine geeignete Wahl des radialen Spalthöhenverlaufs können konkave oder konvexe Temperaturprofile aber auch ein flaches Temperaturprofil eingestellt werden.

Die DE 10 2007 026 348 A1 betrifft ebenfalls einen CVD-Reaktor mit einem Substrathalterträger, auf dessen zur Prozesskammer weisenden Oberfläche eine Vielzahl von Substrathaltern jeweils auf einem dynamischen Drehlager aufliegend angeordnet sind. Jedes dynamische Drehlager ist hier mit einer individuellen Gasversorgung verbunden, so dass die Gasqualität individuell varüerbar ist.

Die DE 100 56 029 A1 betrifft ein Verfahren zur Temperatursteuerung der Oberflächentemperaturen von Substraten in einem CVD-Reaktor. Von an verschiedenen Stellen gemessenen Oberflächentemperaturen werden Mittelwerte gebildet. Über die Höhe der Gaspolster kann die Substrattemperatur eingestellt werden. Auch dies ist individuell für jeden Substrathalter möglich.

Aus der US 7,156,951 B1 ist eine Substratbehandlungsvorrichtung bekannt, bei der ein Substrat auf der Oberfläche eines Substrathalters aufliegt. Die Auflagefläche des Substrathalters bildet mehrere konzentrisch zueinander verlaufende flache Nuten, in die Gaszuleitungen münden und von denen Gasableitungen abgehen. Die Nuten werden mit einem Kühlgas mit einem verschiedenen Druck beaufschlagt.

Aus der DE 695 24 640 T2 ist ein CVD-Reaktor bekannt, bei dem ein Substrathalterträger drei Lagerzapfen trägt, um den jeweils einen kreisscheibenförmiger Substrathalter drehbar gelagert ist, der auf einem Gaspolster drehbar liegt.

Die DD 2 98 435 A5 beschreibt einen Werkstückträger mit einer Vielzahl von Öffnungen, durch die Gas austreten kann, das eine dynamische Gasschicht bildet mit der ein Wärmeübertrag zwischen dem Träger und dem Werkstück verwirklicht ist.

Die US 2009/0173446 A1 beschreibt einen CVD-Reaktor mit einem Substrathalter, der eine Lagerschale aufweist, in der ein Substrat auf einem Gaspolster gelagert werden kann. In den Boden der Lagertasche münden eine Vielzahl von Gaszuleitungen.

Die US 2003/0033116 A1 beschreibt einen beheizbaren Substrathalter mit zwei voneinander getrennten Gaszuleitungen und auf dem Boden einer Lagertasche angeordneten Gaskanälen, die durch die Gaszuleitungen gespeist werden.

Die US 6,053,982 A beschreibt einen CVD-Reaktor mit einem Substrathalter, auf dem die Substrate auf einem Gaspolster aufliegen können.

Die Erfindung befasst sich mit dem Problem, dass bei Substrathaltern für Substrate, die einen Durchmesser von vier Zoll oder größer aufweisen, durch Temperaturgradienten senkrecht zur Oberfläche Verbiegungen an den Substraten entstehen. Dieses Schüsseln oder Aufwölben der Substrate führt zu einem lateralen Temperaturgradienten, da die Substrate entweder nur im zentralen Bereich oder nur im radial äußeren Bereich auf dem Substrathalter aufliegen.

Einhergehend damit ist der Wärmetransport vom Substrathalter zum Substrat inhomogen. Um diese Inhomogenitäten im Wärmetransport zu kompensieren, erzeugt man auf der Substrathalteroberfläche ein entsprechendes konkaves oder konvexes Temperaturprofil.

Der Erfindung liegt die Aufgabe zugrunde, Maßnahmen anzugeben, mit denen sich auf der Substrathalteroberfläche ein konvexes oder konkaves Temperaturprofil erzeugen lässt.

Gelöst wird die Aufgabe durch die in den Ansprüchen angegebene Erfindung.

Der Anspruch 1 sieht zunächst und im Wesentlichen vor, dass das Gaspolster zwischen der Unterseite des Substrathalters mehrere Zonen aufweist, die von individuellen Gaszuleitungen gespeist werden. Die Zonen sind vorzugsweise konzentrisch um die Drehachse des Substrathalters zentriert Im einfachsten Fall besteht das Gaspolster aus zwei Zonen, einer zentralen Zone und einer äußeren Zone. Es können aber auch mehrere Zonen eine zentrale Zone umgeben. Die einzelnen Zonen sind derart voneinander getrennt, dass ein Gasaustausch zwischen benachbarten Zonen vermindert ist. Hierzu sind zwischen den Zonen entsprechende Mittel vorgesehen. Bevorzugt sind die einzelnen Zonen mittels Diffusionsbarrieren voneinander getrennt. Bei einer koaxialen Anordnung der Zonen handelt es sich um ringförmige Diffusionsbarrieren, die verhindern, dass signifikante Mengen des Gases, welches in eine Zone eingespeist wird, in eine benachbarte Zone eintreten. Die Diffusionsbarrieren können eine höhenverminderte Zwischenzone, eine Labyrinthdichtung oder auch eine gespülte Zwischenzone sein. Wesentlich ist, dass mittels der Diffusionsbarriere der Gasaustausch zwischen zwei zueinander benachbarten Zonen minimiert wird. Ursache für einen derartigen Gasaustausch ist im Wesentlichen die Diffusion, die von der bspw. radialen Länge der Diffusionsbarriere und von deren Querschnitt abhängt. Entsprechend ist es von Vorteil, wenn der Querschnitt der Diffusionsbarriere minimiert und die Länge der Diffusionsbarriere, also insbesondere die radiale Länge der Diffusionsbarriere maximiert ist. Ein weiterer Gastransportmechanismus zwischen zwei voneinander benachbarten Zonen ist die Konvektion bzw. eine auf einen Druckunterschied zwischen den beiden Zonen zurückführbare Strömung. Um eine derartige Strömung zu vermeiden, ist es von Vorteil, wenn in den zueinander benachbarten Zonen derselbe Gasdruck herrscht. Die Gase, die in die einzelnen Zonen eingeleitet werden, werden in einem Gasmischsystem bereitgestellt. Es handelt sich um Gase mit stark voneinander abweichenden Wärmeleiteigenschaften. Zur Anwendung kommt insbesondere Stickstoff einerseits und Wasserstoff andererseits bzw. Argon einerseits und Wasserstoff andererseits bzw. Stickstoff einerseits und Helium andererseits sowie Argon einerseits und Helium andererseits. Im einfachsten Fall wird jeweils ein Gas in eine der Zonen eingeleitet und das andere, ein davon stark verschiedene Wärmeleiteigenschaft aufweisende Gas in die andere Zone. Die beiden Gasspalte haben dann verschiedene Wärmetransporteigenschaften. Hierdurch lässt sich der Wärmetransport durch den Gasspalt lokal beeinträchtigen. Bevorzugt werden in die einzelnen Zonen aber Mischungen von mindestens zwei Gasen mit einer unterschiedlichen Wärmeleitfähigkeit eingeleitet. Durch das Mischungsverhältnis der beiden Gase kann der Wärmetransport durch den Gasspalt eingestellt werden. Besitzt bspw. das in die zentrale Zone eingeleitete Gasgemisch eine größere Wärmeleitfähigkeit als das in die äußere Zone eingeleitete Gasgemisch, so erwärmt sich das Zentrum der Oberfläche des Substrathalters stärker, als die Peripherie, so dass die Peripherie eine niedrigere Oberflächentemperatur aufweist, als das Zentrum. Andererseits erwärmt sich die Peripherie stärker als das Zentrum, wenn in das Zentrum eine Gasmischung eingeleitet wird, deren Wärmeleitfähigkeit geringer ist, als die Gasmischung, die in die äußere Zone eingeleitet wird. Dann ist die Oberfläche im Zentrum kälter als im äußeren Bereich. Die Wärme wird von einer Heizung erzeugt, die sich unterhalb des Substrathalterträgers befindet und die den Substrathalterträger aufheizt Oberhalb der Oberseite des Substrathalterträgers bzw. der Substrathalter befindet sich eine in Vertikalrichtung von einem Prozessgas durchströmte Prozesskammer. Das Prozessgas wird bevorzugt - wie grundsätzlich aus dem Stand der Technik bekannt - über ein im Zentrum der Prozesskammer angeordnetes Gaseinlassorgan in die Prozesskammer eingeleitet. Die Prozessgase können die eingangs genannten metallorganischen Komponenten und die eingangs genannten Hydride aufweisen. Die Prozesskammer ist von einem Gasauslassorgan umgeben, mittels welchem Zerlegungsprodukte bzw. das Trägergas abgeleitet werden. Das Gasauslassorgan ist üblicherweise mit einer Vakuumpumpe verbunden, um den Totaldruck in der Prozesskammer in einem Bereich zwischen wenigen Millibar und Atmosphärendruck einstellen zu können. Die oben genannte Diffusionssperre wird vorzugsweise von einer ringförmigen Erhebung der Lagerfläche des Substrathalterträgers ausgebildet. Hierdurch reduziert sich der Querschnitt, durch den ein Gasaustausch zwischen den beiden Zonen stattfinden kann. Die Lagerfläche kann vom Boden einer Tasche ausgebildet sein, in der der Substrathalter einliegt. Der Ring kann aber auch von einem in eine Nut eingesetzten Graphit- oder Metallkörper ausgebildet sein. Die Unterseite des Substrathalters besitzt eine ringförmige Nut, in die die ringförmige Erhebung, also ggf. der Einsatzring, eingreift. Diese Nut besitzt einen Wandabstand, der größer ist, als die Breite des Rings, so dass sich ein mehrfach umgelenkter Dichtungsspalt in der Art einer Labyrinthdichtung ausbildet. Es ist aber ebenso gut möglich, den Ring fest mit der Unterseite des Substrathalters zu verbinden und die Nut dem Boden der Tasche zuzuordnen. Der innenliegenden Zone ist eine Gasableitung zugeordnet, durch die das in die innere Zone eingeleitete Trägergas, bei dem es sich um eine Mischung aus den oben genannten Gasen handeln kann, abgeleitet wird. Es kann sich dabei um eine Bohrung handeln, die zur Unterseite des Substrathalterträgers offen ist. Auch die radial äußeren Zonen können jeweils mit Gasableitungen ausgestattet sein. In einer bevorzugten Ausgestaltung der Erfindung ist jede, und insbesondere die innere Zone, mit einem entlang des äußeren Zonenrandes verlaufenden Gassammelkanal versehen, der mit der Gasablassbohrung kommuniziert. Radial innen bzw. im Zentrum der Zone kann sich darüber hinaus ein Speisekanal befinden, in dem eine Gaszuleitung mündet. Der Speisekanal kann eine Vielzahl von insbesondere spiralförmig verlaufenden Gasverteilkanäle speisen. Durch diese Gasverteilkanäle strömt das Gas mit einer in Umfangsrichtung gerichteten Stromrichtung, so dass es nicht nur den Substrathalter von der Lagerfläche hebt, sondern auch dem Substrathalter einen Drehimpuls aufzwingt, so dass er drehangetrieben wird. Diese spiralförmige Gasverteilkanäle können in jeder Zone vorgesehen sein. Es reicht aber aus, wenn nur eine der Zonen diese Gasverteilkanäle aufweist. So ist es insbesondere vorgesehen, dass nur eine radial außen liegende Zone oder nur eine radial innenliegende zentrale Zone die zum Drehantrieb des Substrathalters erforderlichen Verteilkanäle aufweist. Die Verteilkanäle selbst können verschiedene Gestaltungen aufweisen. Der erfindungsgemäße CVD-Reaktor besitzt eine Vielzahl von um ein Zentrum des Substrathalterträgers angeordnete Lagertaschen in denen jeweils ein Substrathalter mit einem Substrat einliegt. Jede Lagertasche besitzt für jede ihrer Zonen eine individuelle Gaszuleitung. Jede dieser individuellen Gaszuleitungen kann mit einer individuellen Mischkomponente des Gasmischsystems verbunden sein, so dass jede Zone jedes Substrathalters mit einer individuellen Gasmischung beaufschlagt werden kann. Alternativ dazu können aber auch die jeweiligen zentralen Zonen und die jeweiligen radial äußeren Zonen gemeinsam mit einer Gasmischung versorgt werden. Bei dieser Variante erhalten alle zentralen Zonen gemeinschaftlich eine erste Gasmischung und alle radial außen liegenden Zonen gemeinschaftlich eine zweite Gasmischung. Zur Bereitstellung der Gasmischung ist ein Gasmischsystem vorgesehen, welches eine Vielzahl von Gasquellen aufweist, die über Ventile den einzelnen Zuleitungen zuschaltbar sind und die über Massenflusscontroller eingestellt werden können.

Das gattungsgemäße Verfahren zur Temperatursteuerung wird dadurch weitergebildet, dass das Gaspolster mehrere Zonen aufweist, in die Gase bzw. Gasmischungen mit voneinander verschiedenen und insbesondere durch Änderung der Gasmischung einstellbaren Wärmeleiteigenschaften eingespeist werden.

Der CVD-Reaktor wird bevorzugt mit einem Gasmischsystem betrieben, wobei das Gasmischsystem Gasflusskontrollelemente aufweist, mit denen voneinander verschiedene Gase bzw. Gasgemische für die einzelnen Gaszuleitungen bereitstellbar sind.

Ausführungsbeispiele der Erfindung werden nachfolgend anhand beigefügter Zeichnungen erläutert. Es zeigen:

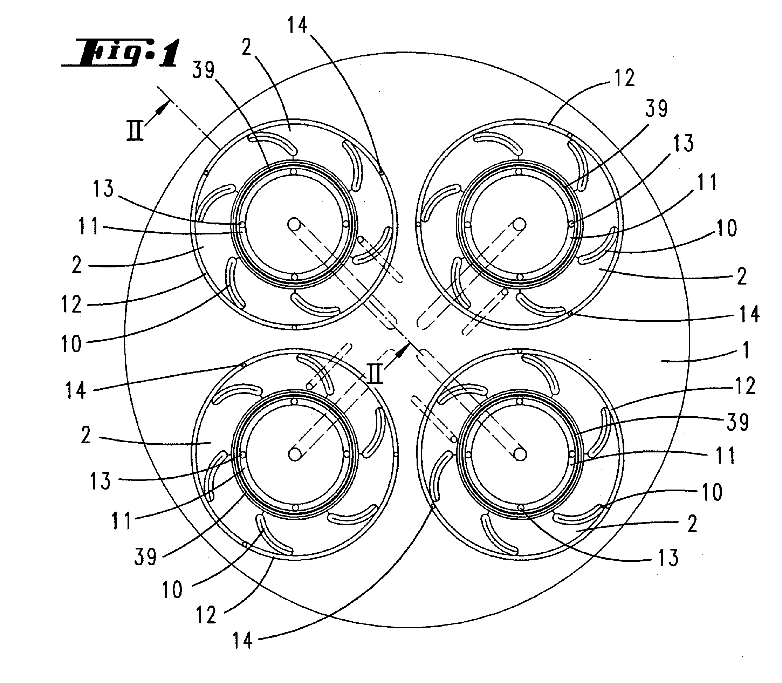

- Fig. 1: eine schematische Darstellung eines Substrathalterträgers 1 in der Draufsicht auf die dort angeordneten Substrathalter 2,
- Fig. 2: einen Schnitt gemäß der Linie II-II in Fig. 1 durch die Hälfte eines Substrathalterträgers 1 einer ersten Variante,

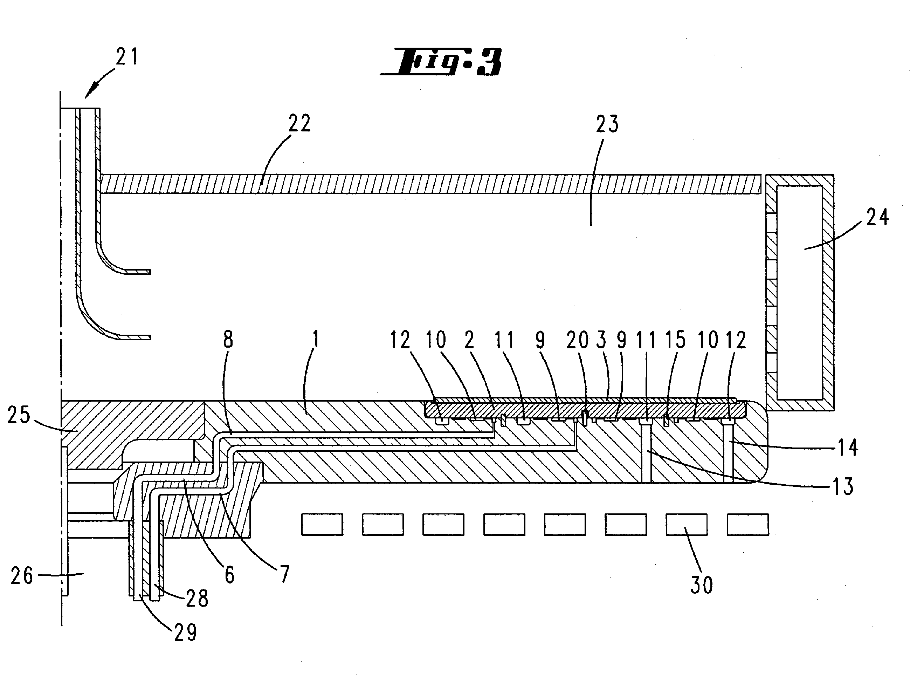

- Fig. 3: eine Darstellung gemäß Fig. 2 einer zweiten Variante,

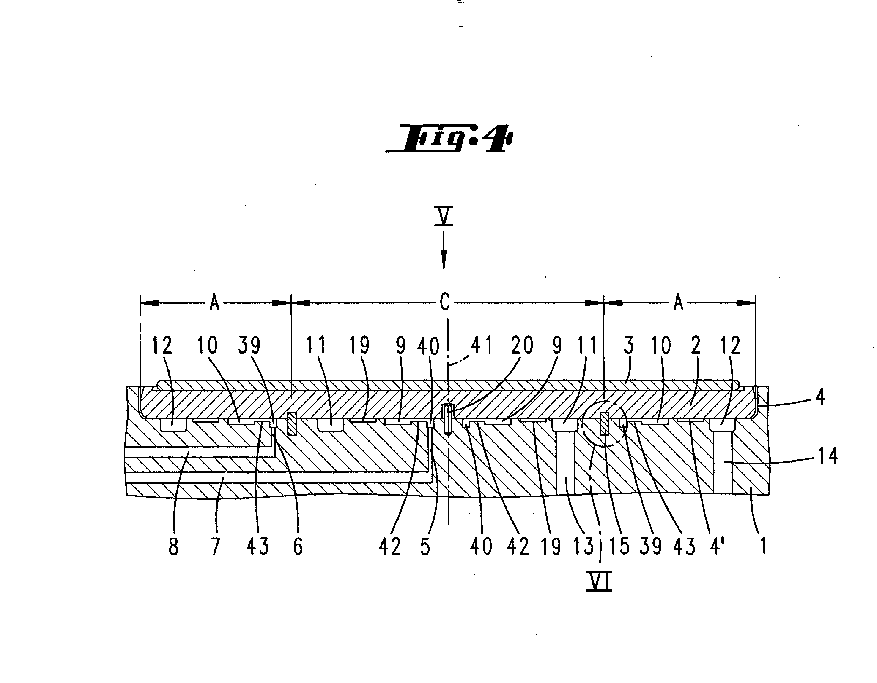

- Fig. 4: vergrößert den Ausschnitt IV in Fig. 3,
- Fig. 5: eine Draufsicht gemäß Pfeil V in Fig. 4,
- Fig. 6: den Ausschnitt VI in Fig. 4 vergrößert,
- Fig. 7: schematisch das Gasmischsystem,
- Fig. 8 -13: verschiedene Alternativen zur Gestaltung des Bodens 4' der Lagertasche 4 in einer Darstellung gemäß Fig. 5,
- Fig. 14: eine schematische Darstellung der Wirkung des Einspeisens von Gasmischungen unterschiedlicher Wärmeleitfähigkeit in die Zonen A bzw. C, und
- Fig. 15: ein weiteres Gasmischsystem.

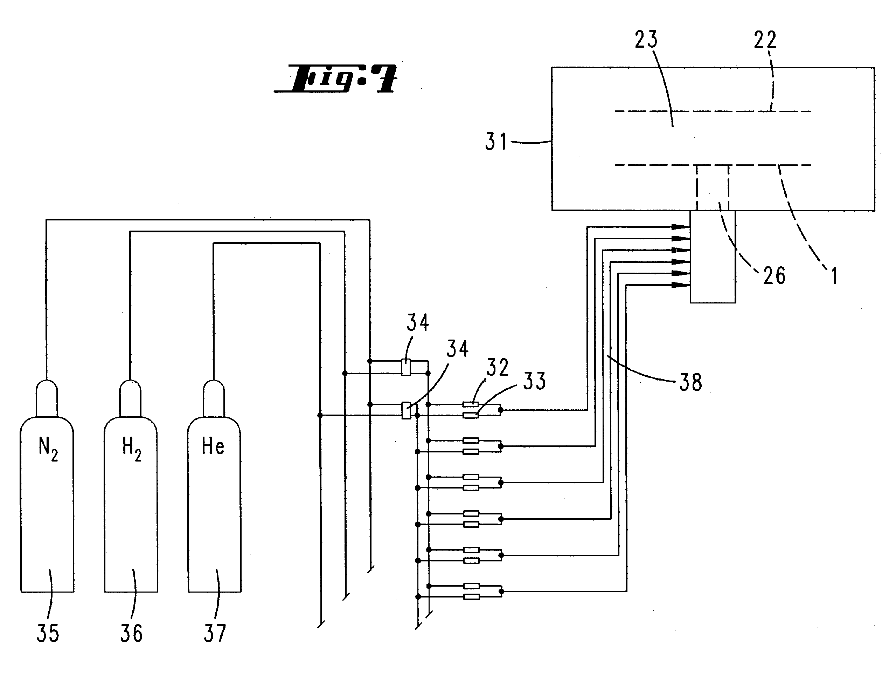

Der CVD-Reaktor besteht aus einem nicht im Detail dargestellten, sondern in Fig. 7 nur angedeuteten gasdichten, insbesondere aus Edelstahl bestehenden Reaktorgehäuse 31, welches mit einem Gasmischsystem gemäß Fig. 7 und einer nicht dargestellten Vakuumpumpe verbunden ist. Innerhalb des Reaktorgehäuses befindet sich die Prozesskammer 23, die nach oben von einer Decke 22, die aus Quarz oder Graphit bestehen kann, begrenzt wird. Die Prozesskammer 23 hat einen radialsymmetrischen Aufbau und besitzt in ihrer Mitte einen Gaseinlass 21, durch den Prozessgase in die Prozesskammer 23 eingeleitet werden können. Der Gaseinlass 21 wird mit Prozessgasen des Gasmischsystems versorgt, bei denen es sich um TMGa, TMIn, TMAl, Arsin, Phosphin oder Methan handeln kann. Zusätzlich wird durch den Gaseinlass 21 ein Trägergas, bspw. Wasserstoff, Stickstoff oder ein Edelgas eingeleitet. Mit der nicht dargestellten Vakuumeinrichtung wird der Totaldruck innerhalb der Prozesskammer 23 auf einem Wert gehalten, der zwischen 1 Millibar und Atmosphärendruck liegt. Radial außen ist die Prozesskammer von einem Gasauslass 24 umgeben, durch welchen die Trägergase bzw. Zerlegungsprodukte abgesaugt werden.

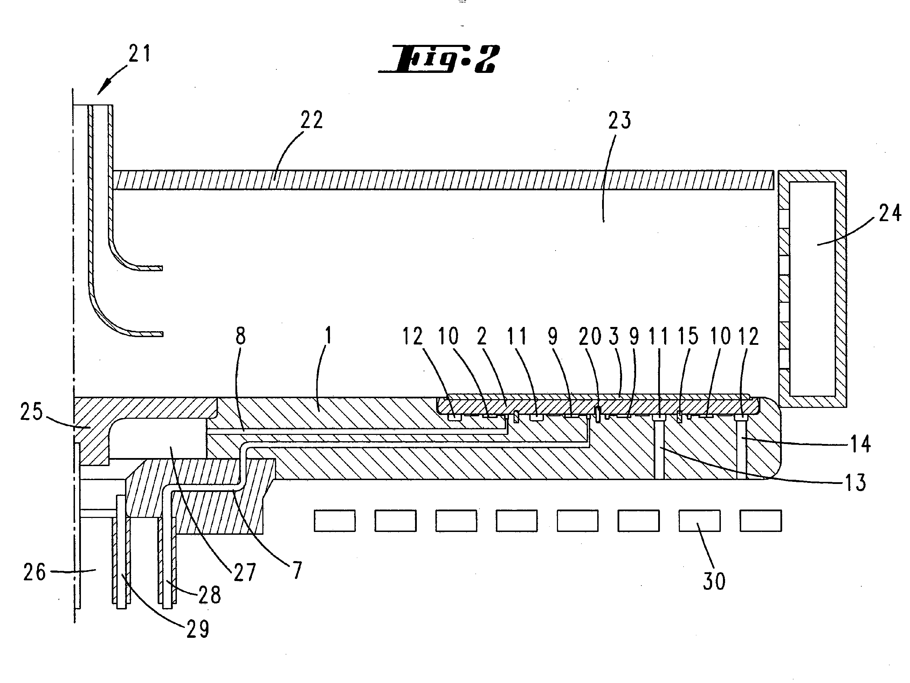

Der Boden der Prozesskammer 23 wird von der nach oben weisenden Oberfläche eines Substrathalterträgers 1 bzw. den nach oben weisenden Oberflächen von Substrathaltern 2 gebildet. Auf den Substrathaltern 2 liegen die zu beschichtenden Substrate 3 auf. Das Zentrum des Bodens der Prozesskammer 23 wird von einer Zentralplatte 25 gebildet, unterhalb der sich bei dem in der Fig. 2 dargestellten Ausführungsbeispiel ein Verteilvolumen 27 befindet. Getragen wird der Substrathalterträger 1 von einem zentralen Träger 26, durch welchen auch Gaszuleitungen 28 und 29 verlaufen.

Die Unterseite des Substrathalterträgers 1 wird von einer Heizung 30 beheizt. Im Ausführungsbeispiel handelt es sich um eine RF-Heizung, die durch Erzeugung von Wirbelströmen in dem aus Graphit bestehenden Substrathalterträger 1 Wärme erzeugt.

Die oben genannten Zuleitungen 28, 29 setzen sich fort in Zuleitungen 7, 8, die mittels Eintrittsöffnungen 6, 7 in der Bodenfläche 4' einer Tasche 4 des Substrathalterträgers 1 münden. Die Zuleitungen 28, 29 sind über äußere Leitungen 38 mit dem Gasmischsystem verbunden. Durch diese Leitungen können individuelle Gasmischungen in die Lagertasche 4 einströmen. Im Ausführungsbeispiel besitzt das Gasmischsystem eine Quelle 35 für Stickstoff, eine Quelle 36 für Wasserstoff und eine Quelle 37 für Helium. Über Umschaltventile 34, 35 können diese Gase jeweils auf Massencontroller 32, 33 geschaltet werden, mit denen individuell die Gaszusammensetzung eingestellt werden kann, die durch die Eintrittsöffnungen 6, 7 an verschiedenen Stellen in die Lagertasche einströmen. Die von den Massencontrollern 32, 33 zusammengemischten Gase bestehen aus zwei Gasen mit stark unterschiedlichen Wärmeleiteigenschaften, bspw. den Gaspaarungen N₂-H₂, Ar-H₂, N₂-He, Ar-He. Durch Einstellung der Gaszusammensetzung kann die Wärmeleiteigenschaft der Gasmischung durchgestimmt werden.

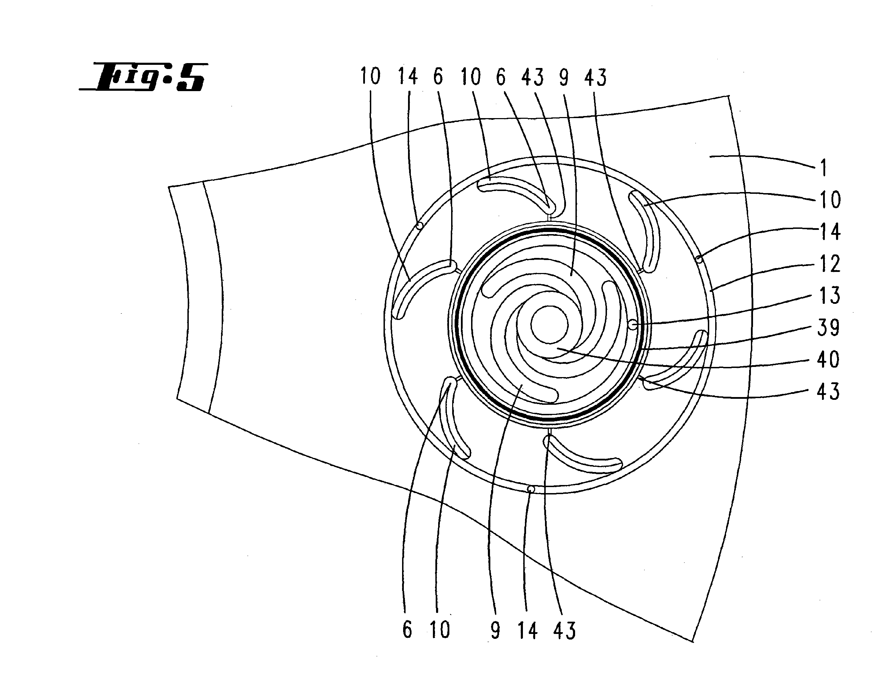

Der Boden 4' der Lagertasche 4 kann auf unterschiedliche Weise strukturiert werden. Die Figuren 5 bzw. 8 bis 13 geben hierzu Beispiele an.

Bei allen Ausführungsbeispielen wird der Boden 4' der Lagertasche 4 in zwei konzentrische Zonen geteilt. Eine innere konzentrische Zone C erstreckt sich um das Zentrum, in welchem sich ein optionaler Zentrierstift 20 befindet, der in einer Zentrieröffnung des Substrathalters 2 eingreift. Um das Zentrum 41 ist ein erster Speisekanal 40 angeordnet, in den die Eintrittsöffnung 5 der Zuleitung 7 mündet. Über einen schmalen Verbindungskanal 42 ist der Speisekanal 40 mit einem auf einer Spiralkurve verlaufenden Gasverteilkanal 9 verbunden. Das durch den Gasverteilkanal 9 strömende Gas hebt nicht nur den Substrathalter 2 in eine Spaltstellung, sondern bringt den Substrathalter 2 auch in eine Drehbewegung um das Zentrum 41.

Im radialen äußeren Bereich der Zone C befindet sich ein auf einer Kreislinie verlaufender Gassammelkanal 11, der mit einer Ableitung 13 verbunden ist. Bei der Ableitung 13 handelt es sich um eine durchmessergroße Vertikalbohrung durch den Substrathalterträger 1, durch die das durch die Eintrittsöffnung 5 eingespeiste Gas wieder austreten kann.

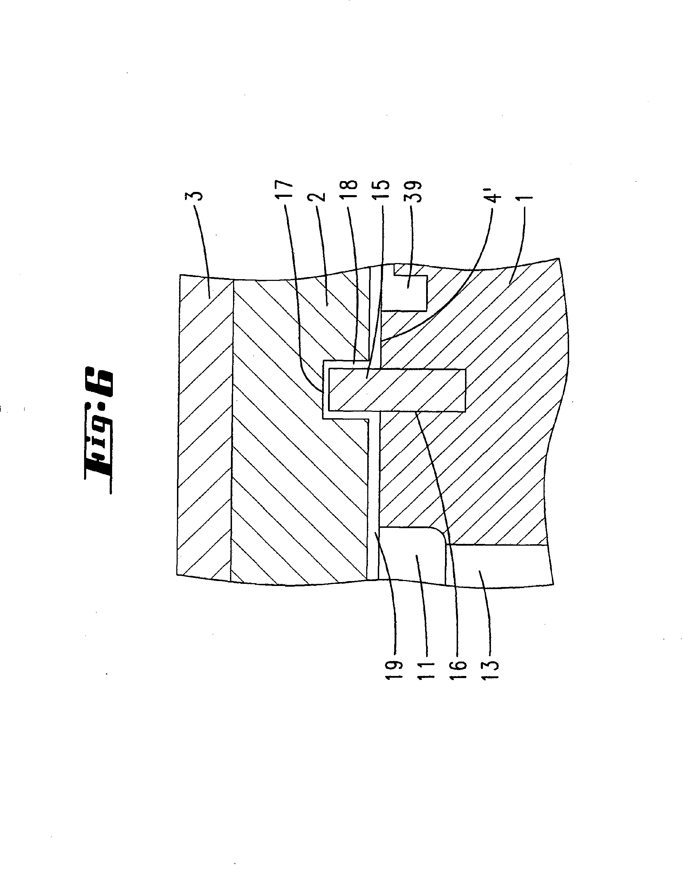

Die Grenze zwischen der zentralen Zone C und der äußeren Ringzone A wird von einer Diffusionsbarriere gebildet, deren Aufbau der Fig. 6 zu entnehmen ist. Ein Ring 15 steckt in einer Bodenringnut 16 des Bodens 4' der Lagertasche 4 ein. Er ragt aus dem Boden 4' heraus und in eine Ringnut 17 der Rückseite des Substrathalters ein. Die Breite der Ringnut 17 ist größer, als die Breite des Dichtrings 15, so dass sich ein geringfügiger Dichtungsspalt 18 ergibt. Dieser bildet eine Art Labyrinthdichtung zwischen den Zonen A und C aus.

Im radial inneren Bereich der Zone A erstreckt sich auf dem Boden 4' der Lagertasche 4 ein erster konzentrischer Ring, der einen Speisekanal 39 ausbildet und der mit der Eintrittsöffnung 6 verbunden ist. Über Verbindungskanäle 43 ist der Speisekanal 39 mit ebenfalls auf Spiralkurven verlaufenden Gasverteilkanälen 10 verbunden. Im radial äußeren Bereich der Zone A befindet sich ein Gassammelkanal 12, der mit einer durchmessergroßen Ableitung 14 verbunden ist, bei der es sich ebenfalls um eine durchmessergroße Vertikalbohrung handelt. Durch die Ableitung 14 kann das über die Eintrittsöffnung 6 eingebrachte Gas entweichen.

Die Höhe des Substrathalters 2 entspricht in etwa der Tiefe der Lagertasche 4 und der Substrathalter 2 besitzt auf seiner zur Prozesskammer 23 weisenden Oberfläche eine Vertiefung, in der das Substrat 3 liegt.

Bei dem in der Fig. 2 dargestellten Ausführungsbeispiel mündet die Zuleitung 29 in eine Gasverteilkammer 27, von welcher aus alle Zuleitungen 8, die in radial äußere Zonen münden, gespeist werden. Die Zuleitungen 28 für die zentrale Zone C können auch gemeinschaftlich mit einer Gasmischung gespeist werden.

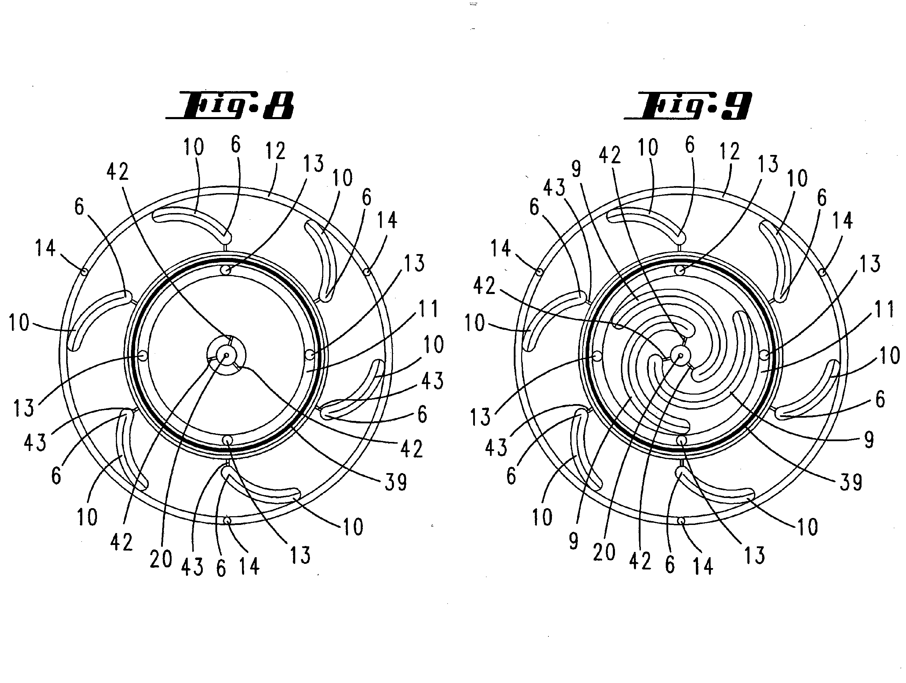

Bei dem in der Fig. 8 dargestellten Ausführungsbeispiel befinden sich nur in der radial äußeren Zone A Spiralkanäle 10. Bei dem in der Fig. 9 dargestellten Ausführungsbeispiel befinden sich sowohl in der inneren Zone C als auch in der äußeren Zone A Spiralkanäle 9, 10.

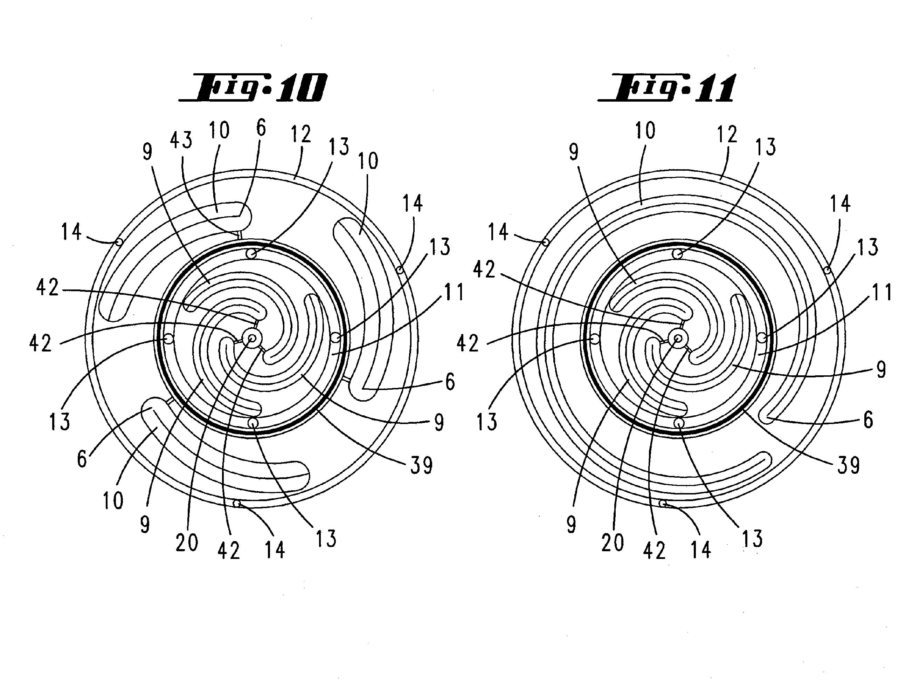

Bei dem in der Fig. 10 dargestellten Ausführungsbeispiel befinden sich in der radial äußeren Zone A breite Spiralkanäle 10.

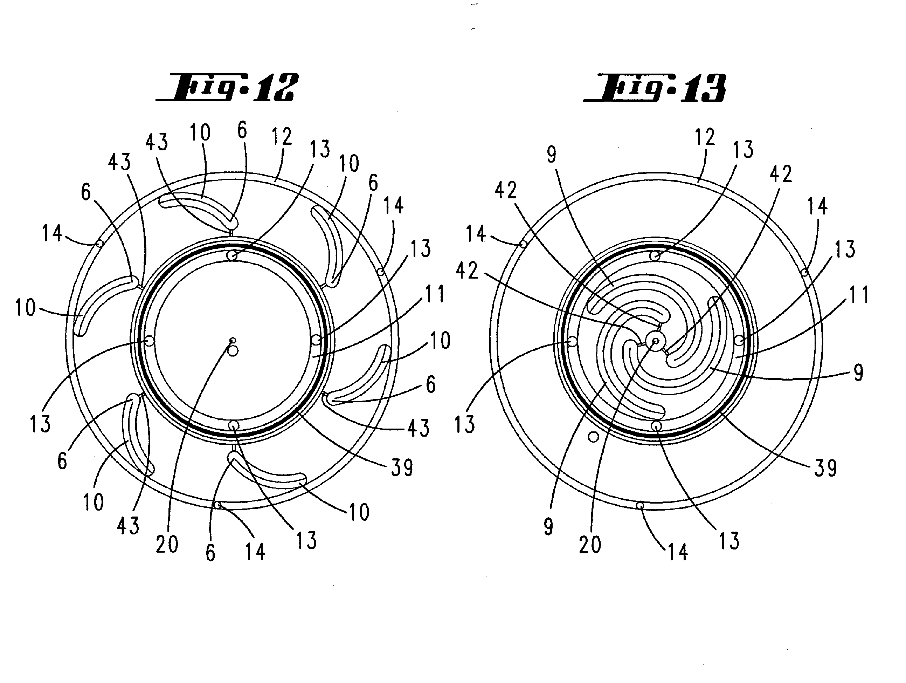

Bei dem in der Fig.11 dargestellten Ausführungsbeispiel besitzt die radial äußere Zone A lediglich einen, spiralförmig verlaufenden Gaskanal 10. Die Fig. 12 zeigt ebenso wie die Fig. 8 lediglich in der äußeren Zone A angeordnete Gaskanäle. Die Fig. 13 zeigt ein Ausführungsbeispiel, bei dem nur in der zentralen Zone C mehrere Gaskanäle 9 vorgesehen sind.

Die Funktionsweise der zuvor beschriebenen Vorrichtung ist die Folgende:
Bei einem Beschichtungsprozess können sich die Ränder des Substrates 3 aufwölben bzw. absenken, so dass entweder nur das Zentrum des Substrates oder nur der Rand des Substrates 3 flächig auf der Oberfläche des Substrathalters 2 aufliegt. Ansonsten befindet sich zwischen Substrat 3 und Substrathalter 2 ein Spalt mit unter Umständen örtlich verschiedener Spalthöhe.

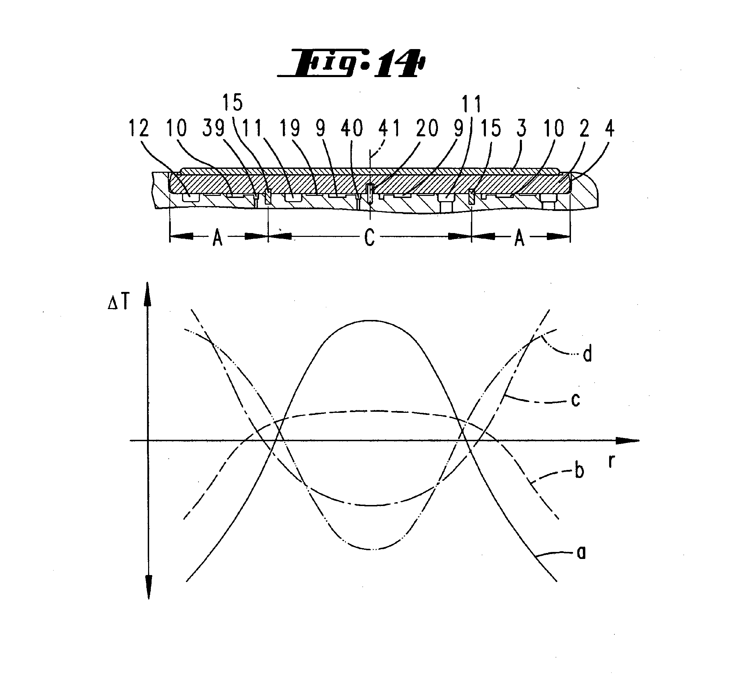

Die Qualität und die Schichtdicke der auf dem Substrat 3 abgeschiedenen Schichten hängt in hohem Maße von der Substratoberflächentemperatur ab. Letztere ist vom lokalen Wärmezufluss abhängig. Der lokale Wärmezufluss wird erfindungsgemäß durch eine Beeinflussung der Wärmeleiteigenschaften des Gasspaltes zwischen Boden 4' der Lagertasche 4 und Unterseite des Substrathalters 2 eingestellt. Das durch die Eintrittsöffnungen 5, 6 in die Lagertasche 4 eintretende Gas hebt den Substrathalter 2 in eine Spaltabstandsstellung, so dass sich ein Gaspolster 19 ausbildet. Wegen der Diffusionssperre 15 handelt es sich um zwei getrennte Gaspolster 19, die individuell durch Gase, die durch die Eintrittsöffnungen 5, 6 in den Spaltzwischenraum eintreten, aufgebaut werden. Die in die einzelnen Zonen A, C eingeleiteten Gasmischungen besitzen unterschiedliche Wärmeleitfähigkeiten. Wird bspw. in die Zentrumszone C eine Gasmischung mit einer hohen Wärmeleitfähigkeit und in die äußere Zone A eine Gasmischung mit einer geringen Leitfähigkeit eingebracht, so stellt sich auf der Oberfläche des Substrathalters 2 ein Temperaturprofil ein, wie es in der Fig. 14 mit a schematisch dargestellt ist. Besitzt das in die zentrale Zone C eingeleitete Gas nur eine gering höhere Leitfähigkeit als das in die äußere Zone A eingeleitete Gas, so stellt sich das in der Fig. 14 mit b bezeichnete Temperaturprofil ein.

Besitzt die Gasmischung, die in die äußere Zone A eingeleitet wird, eine größere Wärmeleitfähigkeit als die Gasmischung, die in die zentrale Zone C eingeleitet wird, so stellt sich das in der Fig. 14 mit c dargestellte Temperaturprofil ein. Jetzt ist anders als bei den Beispielen a und b nicht der Zentralbereich heißer als der periphere Bereich, sondern der äußere Bereich hat eine größere Oberflächentemperatur als der zentrale Bereich. Der Temperaturunterschied zwischen zentralem Bereich und äußeren Bereich kann noch erhöht werden, in dem der Unterschied der Wärmeleitfähigkeiten der eingeleiteten Gasmischungen vergrößert wird. Durch Verwendung anderer Gaspaarungen lassen sich die Temperaturprofilkurven nicht nur quantitativ, sondern auch qualitativ beeinflussen, dies zeigt bspw. das mit d dargestellte Temperaturprofil.

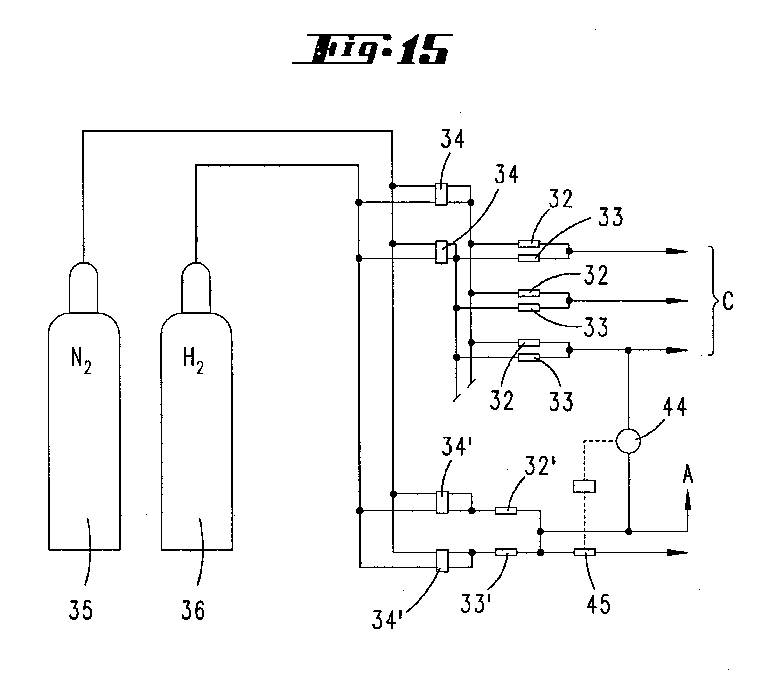

Bei dem in der Fig. 15 dargestellten Gasmischsystem werden zwei Gase 35, 36, nämlich Stickstoff und Wasserstoff, bereitgestellt. Die einzelnen Gase werden über Zuleitung und Umschaltventile 34 Massenflusscontrollern 32, 33 zugeleitet. Bei diesem Ausführungsbeispiel sind drei Substrathalter vorgesehen, die jeweils getrennt in der zentralen Zone 10 mit einer Mischung der Gase 35, 36 versorgt werden. In entsprechender Weise werden die Gasströme durch die Massenflusscontroller 32, 33 eingestellt.

Die äußere Ringzone wird in ähnlicher Weise über die Umschaltventile 34' und die Massenflusscontroller 32', 33' mit einer Gasmischung versorgt. Bei diesem Ausführungsbeispiel ist zwischen einer Zuleitung zu einer inneren Zone C und der äußeren Zone A ein Druckregler 44 vorgesehen. Bei diesem Druckregler handelt es sich um eine Differenzdruckdose, so dass ein Druckunterschied in den beiden Zonen A und C eingestellt werden kann. Der Druck in der Zuleitung zur Zone A wird darüber hinaus über einen Durchflussdruckregler 45 eingestellt, der mit einer Vent-Leitung verbunden ist.

### Bezugszeichenliste

| | | | |
|---|---|---|---|
| 1 | Substrathalterträger | | |
| 2 | Substrathalter | | |
| 3 | Substrat | | |
| 4 | Lagertasche | | |
| 4' | Lagerfläche | | |
| 5 | Eintrittsöffnung | | |
| 6 | Eintrittsöffnung | | |
| 7 | Zuleitung | | |
| 8 | Zuleitung | | |
| 9 | Gasverteilkanal | | |
| 10 | Gasverteilkanal | | |
| 11 | Gassammelkanal | | |
| 12 | Gassammelkanal | | |
| 13 | Ableitung | | |
| 14 | Ableitung | | |
| 15 | Dichtring (Diffusionsbarriere) | | |
| 16 | Ringnut | | |
| 17 | Ringnut | | |
| 18 | Spalt | | |
| 19 | Gaspolster | | |
| 20 | Zentrierstift | | |
| 21 | Gaseinlass | | |
| 22 | Decke | | |
| 23 | Prozesskammer | | |
| 24 | Gasauslass | | |
| 25 | Zentrierplatte | | |
| 26 | Träger | | |
| 27 | Verteilkammer | | |
| 28 | Zuleitung | | |
| 29 | Zuleitung | | |
| 30 | Heizung | | |
| 31 | Reaktorgehäuse | | |
| 32 | Massenflusscontroller | 32' | Massenflusscontroller |
| 33 | Massenflusscontroller | 33' | Massenflusscontroller |
| 34 | Umschaltventil | 34' | Umschaltventil |
| 35 | Gasquelle | | |
| 36 | Gasquelle | | |
| 37 | Gasquelle | | |
| 38 | Leitungen | | |
| 39 | Speisekanal | | |
| 40 | Drehachse | | |
| 41 | Verbindungskanal | | |
| 42 | Verbindungskanal | | |
| 43 | Verbindungskanal | | |
| 44 | Druckregler | | |
| 45 | Druckregler | | |
| | | | |
| A | äußere konzentrische Zone | | |
| C | innere Ringzone | | |
| | | | |
| a | Temperaturprofil | | |
| b | Temperaturprofil | | |
| c | Temperaturprofil | | |

## Patentansprüche

1. CVD-Reaktor mit einer Prozesskammer (23) und einem darin angeordneten Substrathalterträger (1), der mindestens eine Lagerfläche (4') aufweist, wobei in die Lagerfläche (4') mehrere Gaszuleitungen (7, 8) münden, mit einem mit seiner Rückseite zur Lagerfläche (4') weisenden Substrathalter (2), wobei die durch die Gaszuleitungen (7, 8) in den Raum zwischen Lagerfläche (4') und Rückseite eingespeisten Gase ein Gaspolster (19) bilden, das den Substrathalter (2) trägt, **dadurch gekennzeichnet, dass** das Gaspolster mehrere, jeweils durch eine zugeordnete Gaszuleitung (7, 8) individuell speisbare Zonen (A, C) aufweist, die durch einen Gasaustausch zwischen den Zonen (A, C) hemmende Mittel (15) voneinander getrennt sind, wobei zumindest einer innenliegenden Zone (C) eine Gasableitung (13,14) zugeordnet ist, durch die das in die innenliegende Zone (C) durch die Zuleitung (7, 8) eingespeiste Gas ableitbar ist.

2. CVD-Reaktor nach Anspruch 1, **dadurch gekennzeichnet, dass** die einen Gasaustausch zwischen den Zonen hemmende Mittel (15) eine ringförmig ein Drehzentrum des Substrathalters (2) umgebende Diffusionsbarriere (15) bilden.

3. CVD-Reaktor nach Anspruch 2, **dadurch gekennzeichnet, dass** die Diffusionsbarriere (15) ein über eine Fläche, insbesondere die Lagerfläche (4') des Substrathalterträgers (1) ragender, insbesondere in eine Nut (16) eingesetzter Ring (15) ist, der in eine auf der gegenüberliegenden Fläche, insbesondere der Rückseite des Substrathalters (2) angeordnete Ringnut (17) derart eingreift, dass sich zwischen den Gaspolstern der beiden Zonen (A, C) lediglich ein mehrfach umgelenkter Spalt (18) verbleibt.

4. CVD-Reaktor nach einem der vorhergehenden Ansprüche, **dadurch gekennzeichnet, dass** mehreren innenliegenden Zonen (C) jeweils eine Gasableitung (13, 14) zugeordnet ist.

5. CVD-Reaktor nach Anspruch 4, **dadurch gekennzeichnet, dass** die Gasableitung (13,14) mit einem insbesondere radial außen liegenden Gassammelkanal (11, 12) kommuniziert, der sich in Umfangsrichtung entlang des Randes der Zone (A, C) erstreckt.

6. CVD-Reaktor nach einem der vorhergehenden Ansprüche, **dadurch gekennzeichnet, dass** die Zuleitung (7) mit einem Speisekanal (39, 40) kommuniziert, der insbesondere radial innenliegend sich entlang eines Umfangsrandes der Zone (A, C) erstreckt.

7. CVD-Reaktor nach einem der vorhergehenden Ansprüche, **dadurch gekennzeichnet, dass** der Substrathalter (2) in einer Tasche (4) des Substrathalterträgers (1) einliegt, wobei der Taschenboden (4') der Tasche (4) die Lagerfläche ausbildet, parallel zu welcher die Rückseite des Substrathalters (2) verläuft, auf dessen nach oben in Richtung einer Decke (22) einer Prozesskammer (23) weisenden Seite ein Substrat (3) anordenbar ist, wobei der Taschenboden (4') einen Speisekanal (39, 40) und einen damit kommunizierenden, insbesondere auf einer Spirallinie verlaufenden Gasverteilkanal (9,10) aufweist und wobei der Gasverteilkanal (9, 10) von einem Gassammelkanal (11, 12) umgeben ist, der mit einer Ableitung (13,14) kommuniziert.

8. CVD-Reaktor nach einem der vorhergehenden Ansprüche, **gekennzeichnet durch** eine Vielzahl von in kreisförmiger Anordnung um ein Zentrum des Substrathalterträgers (1) angeordnete Lagertaschen (4), die jeweils einen Substrathalter (2) aufnehmen, der jeweils von einem Gaspolster (19) mit mehreren Zonen (A, C) getragen wird, wobei Zuleitungen (7, 8) für die einzelnen Zonen (A, C) vorgesehen sind, die entweder individuell mit einer Gasversorgungseinrichtung oder mit einer gemeinsamen Gasversorgungseinrichtung verbunden sind.

9. Verfahren zur Temperatursteuerung der Oberflächentemperaturen eines auf einem dynamischen Gaspolster (19) getragenen und insbesondere drehangetriebenen, von unten beheizten Substrathalters (2), **dadurch gekennzeichnet, dass** das Gaspolster (19) mehrere insbesondere koaxial zueinander angeordnete Zonen (A, C) aufweist, in die Gase (35, 36, 37) bzw. Gasmischungen mit voneinander verschiedenen und insbesondere durch Änderung der Gasmischung einstellbaren Wärmeleiteigenschaften eingespeist werden.

10. Vorrichtung zum Behandeln von Substraten mit einem CVD-Reaktor, aufweisend eine Prozesskammer (23) und einem darin angeordneten Substrathalterträger (1), der auf seiner zur Prozesskammer (23) weisenden Seite auf einer Lagerfläche (4') einen Substrathalter (2) trägt und von seiner Rückseite her mit einer Heizung (30) beheizbar ist, wobei in die Lagerfläche (4') Gaszuleitungen (7, 8) münden, die von einem Gasmischsystem mit Gasen gespeist werden, die ein den Substrathalter (2) tragendes dynamisches Gaspolster ausbilden, **dadurch gekennzeichnet, dass** das Gaspolster (19) mehrere aneinander grenzende Zonen (A, C) aufweist, die durch individuelle Gaszuleitungen (7, 8) vom Gasmischsystem gespeist werden, wobei das Gasmischsystem Gasflusskontrollelemente (32, 33, 34) aufweist, mit denen voneinander verschiedene Gase bzw. Gasgemische für die einzelnen Gaszuleitungen (7, 8) bereitstellbar sind.

11. Vorrichtung nach Anspruch 10, **dadurch gekennzeichnet, dass** das Gasmischsystem eine erste Quelle (35) für ein erstes Gas und eine zweite Quelle (36) für ein zweites Gas aufweist, wobei die beiden voneinander verschiedene Wärmeleiteigenschaften aufweisenden Gase mittels der Gasflusskontrollelemente (32, 33, 34) individuell mischbar sind, um durch Einstellung der Gaszusammensetzung die Wärmeleiteigenschaft des Gaspolsters in jeder der Zonen (A, C) individuell einzustellen.

## Claims

1. CVD reactor comprising a process chamber (23) and a substrate holder carrier (1) located therein, the carrier having at least one bearing surface (4), a plurality of gas supply lines (7, 8) opening into the bearing surface (4'), the carrier having a substrate holder (2), the rear side of which faces toward the bearing surface (4'), gases fed into the space between the bearing surface (4') and the rear side through the gas supply lines (7,8) forming a gas cushion (19) which carries the substrate holder (2), **characterized in that** the gas cushion has a plurality of zones (A, C) that can be individually fed, in each case through an associated gas supply line (7, 8), the zones being separated from one another by means (15) that inhibit an exchange of gas between the zones (A, C), a gas discharge line (13, 14) being associated at least with an inwardly lying zone (C), through which discharge line the gas fed into the inwardly lying zone (C) through the supply line (7, 8) can be discharged.

2. CVD reactor according to Claim 1, **characterized in that** the means (15) inhibiting an exchange of gas between the zones forms a diffusion barrier (15) that surrounds in an annular manner a center of rotation of the substrate holder (2).

3. CVD reactor according to claim 2, **characterized in that** the diffusion barrier (15) is a ring (15) that projects above a surface of the substrate holder carrier (1), in particular its bearing surface (4'), and is in particular inserted into a groove (16), the ring engaging in an annular groove (17) located on the opposite surface, in particular the rear surface of the substrate holder (2), in such a way that there remains between the gas cushions of the two zones (A, C) only a gap which changes direction a number of times.

4. CVD reactor according to any of the preceding claims, **characterized in that** in each case a gas discharge line (13, 14) is associated with a plurality of inwardly lying zones (C).

5. CVD reactor according to claim 4, **characterized in that** the gas discharge line (13, 14) communicates with an in particular radially outwardly disposed gas collecting channel (11, 12), which extends in the circumferential direction along the edge of the zones (A, C).

6. CVD reactor according to any of the preceding claims, **characterized in that** the supply line (7) communicates with a feed channel (39, 40), which extends, in particular in a radially inwardly located manner, along a peripheral edge of the zone (A, C).

7. CVD reactor according to any of the preceding claims, **characterized in that** the substrate holder (2) is enclosed in a pocket (4) of the substrate holder carrier (1), the pocket base (4') of the pocket (4) forming the bearing surface, parallel to which there runs the rear side of the substrate holder (2), on which holder a substrate (3) can be disposed on the side of the holder that faces upwardly in the direction of a cover (22) of a process chamber (23), the pocket base (4') having a feed channel (39, 40) and a gas distribution channel (9, 10) that communicates therewith and in particular runs in a spiral, and the gas distribution channel (9, 10) being surrounded by a gas collection channel (11, 12) which communicates with a discharge line (13, 14).

8. CVD reactor according to any of the preceding claims, **characterized by** a multiplicity of bearing pockets (4) disposed in a circular arrangement around a center of the substrate holder carrier (1), each pocket accommodating a substrate holder (2), which is respectively carried by a gas cushion (19) that has a plurality of zones (A, C), supply lines (7, 8) being provided for the individual zones (A, C), the supply lines being either connected individually to a gas supply device or to a common gas supply device.

9. Method for temperature control of the surface temperatures of a substrate holder (2) that is heated from below, is carried on a dynamic gas cushion (19) and is in particular driven in rotation, **characterized in that** the gas cushion (19) has a plurality of zones (A, C) that are in particular arranged coaxially with respect to one another, into which zones, gases (35, 36, 37) or mixtures of gases are fed that have heat conduction properties which differ from one another and are in particular adjustable by changing the gas mixture.

10. Apparatus for treating substrates comprising a CVD reactor that has a process chamber (23) and a substrate holder carrier (1) arranged therein which carries a substrate holder (2) on a bearing surface (4') on the side of the carrier that faces toward the process chamber (23) and can be heated from its rear side by a heater (30), gas supply lines (7, 8) opening into the bearing surface (4'), the lines being fed by a gas mixing system with gases that form a dynamic gas cushion which carries the substrate holder (2), **characterized in that** the gas cushion (19) has a plurality of zones (A, C) that are adjacent to one another and are fed from the gas mixing system through individual gas supply lines (7, 8), the gas mixing system having gas flow control elements (32, 33, 34, 35) by which gases that are different from one another or gas mixtures can be supplied for the individual gas supply lines (7, 8).

11. Apparatus according to Claim 10, **characterized in that** the gas mixing system has a first source (35) for a first gas and a second source (36) for a second gas, wherein the two gases that have heat conduction properties which are different from one another can be individually mixed by means of the gas flow control elements (32, 33, 34, 35), in order to adjust individually the heat conduction property of the gas cushion in each of the zones (A, C) by adjustment of the composition of the gas.

## Revendications

1. Réacteur CVD comprenant une chambre de traitement (23) et un porte-support de substrat (1) disposé à l'intérieur, qui présente au moins une surface d'appui (4'), plusieurs arrivées de gaz (7, 8) débouchant dans la surface d'appui (4'), avec un support de substrat (2) dirigé avec sa face arrière vers la surface d'appui (4'), les gaz injectés par les arrivées de gaz (7, 8) dans l'espace entre la surface de palier (4') et la face arrière formant un matelas de gaz (19), lequel porte le support de substrat (2), **caractérisé en ce que** le matelas de gaz présente plusieurs zones (A, C) pouvant être alimentées à chaque fois par une arrivée de gaz (7, 8) attribuée, qui sont séparées les unes des autres par des moyens (15) empêchant un échange de gaz entre les zones (A, C), une évacuation de gaz (13, 14) étant attribuée au moins à une zone intérieure (C), évacuation par laquelle le gaz injecté dans la zone intérieure (C) par l'arrivée (7, 8) est évacué.

2. Réacteur CVD selon la revendication 1, **caractérisé en ce que** les moyens (15) empêchant un échange de gaz entre les zones forme une barrière de diffusion (15) en forme d'anneau entourant un centre de rotation du support de substrat (2).

3. Réacteur CVD selon la revendication 2, **caractérisé en ce que** la barrière de diffusion (15) est sur une surface, en particulier la surface d'appui (4') du porte-support de substrat (1) faisant saillie en particulier en anneau (15) inséré dans une rainure (16), laquelle vient en prise dans une rainure en anneau (17) agencée dans la surface opposée, en particulier la face arrière du support de substrat (2), de sorte que entre les matelas de gaz des deux zones (A, C) reste seulement une fente (18) changeant de direction plusieurs fois.

4. Réacteur CVD selon l'une des revendications précédentes, **caractérisé en ce que** plusieurs zones intérieures (C) ont chacune une évacuation de gaz (13, 14).

5. Réacteur CVD selon la revendication 4, **caractérisé en ce que** les évacuations de gaz (13, 14) communiquent avec un canal de collecte de gaz (11, 12) en particulier s'étendant radialement extérieurement, qui s'étend dans la direction circonférentielle le long du bord de la zone (A, C).

6. Réacteur CVD selon l'une des revendications précédentes, **caractérisé en ce que** l'arrivée (7) communique avec un canal d'alimentation (39, 40) qui s'étend en particulier radialement intérieurement le long d'un bord périphérique de la zone (A, C).

7. Réacteur CVD selon l'une des revendications précédentes, **caractérisé en ce que** le support de substrat (2) s'insère dans une poche (4) du porte-support de substrat (1), dans lequel le fond de la poche (4') de la poche (4) forme la surface d'appui parallèlement à laquelle la face arrière du support de substrat (2), sur laquelle un substrat (3) peut être agencé vers le haut en direction d'un plafond (22) d'un côté présentant une chambre de traitement (23), dans lequel le fond du sac (4') présente un canal d'alimentation (39, 40) et un canal de répartition de gaz (9, 10) communiquant avec celui-ci, s'étendant en particulier sur une ligne en spirale, et dans lequel le canal de répartition de gaz (9, 10) est entouré d'un canal de collecte de gaz (11, 12), lequel communique avec à une évacuation (13, 14).

8. Réacteur CVD selon l'une des revendications précédentes, **caractérisé par** une pluralité de poches de palier (4) agencées dans un arrangement circulaire autour d'un centre du porte-support de substrat (1), qui chacune accueille un support de substrat (2), qui chacun est porté par un coussin de gaz (19) avec plusieurs zones (A, C), dans lequel des arrivées (7, 8) sont prévues pour chaque zone isolée (A, C), qui sont connectées soit individuellement à un dispositif d'alimentation en gaz soit ou à un dispositif commun d'alimentation en gaz.

9. Procédé pour le contrôle de température de la température de surface d'un support de substrat (2) chauffé par le dessous, porté sur un coussin de gaz dynamique (19) et en particulier entraîné en rotation, **caractérisé en ce que** le coussin à gaz (19) présente plusieurs zones (A, C), en particulier disposée coaxialement, dans lesquelles les gaz (35, 36, 37), respectivement les mélanges de gaz sont alimentés avec différentes propriétés de conductivité thermique différentes les unes des autres et en particulier réglable par la modification du mélange de gaz.

10. Appareil de traitement de substrats avec un réacteur CVD, présentant une chambre de traitement (23) et un porte-support de substrat (1) disposé à l'intérieur, qui porte, sur son côté présentant la chambre de traitement (23), un support de substrat (2) sur une surface d'appui (4') et est chauffable de sa face arrière avec un chauffage (30), dans lequel des arrivées de gaz (7, 8) débouchent dans la surface d'appui (4'), et sont alimentées par un système de mélange de gaz avec des gaz, qui forment un matelas dynamique de gaz (19) portant le support de substrat (2), **caractérisé en ce que** le matelas de gaz présente plusieurs zones (A, C) avoisinantes les unes aux autres, qui sont alimentées par des arrivées de gaz (7, 8) individuelles du système de mélange de gaz, dans lequel le système de mélange de gaz présente des éléments de contrôle du flux de gaz (32, 33, 34), avec lesquels des gaz différentes les uns des autres, respectivement des mélanges de gaz peuvent être mis à la disposition des arrivées de gaz (7, 8).

11. Dispositif selon la revendication 10, **caractérisé en ce que** le système de mélange de gaz présente une première source (35) pour un premier gaz et une seconde source (36) pour un second gaz, dans lequel les deux gaz présentant des propriétés de conductivités thermiques différentes l'une de l'autre sont mélangés individuellement au moyen des éléments de contrôle du flux de gaz (32, 33, 34) afin de régler de manière individuelle dans chaque zone (A, C) la propriété de conductivité thermique du matelas de gaz par l'ajustement de la composition du gaz.
